(19) Europäisches Patentamt
European Patent Office
Office européen des brevets

(11) EP 4 432 471 A1

(12) **EUROPEAN PATENT APPLICATION**

(43) Date of publication:
**18.09.2024 Bulletin 2024/38**

(21) Application number: **23161381.1**

(22) Date of filing: **13.03.2023**

(51) International Patent Classification (IPC):
***H01Q 13/20*** *(2006.01)* ***G01R 31/11*** *(2006.01)*
***H04B 3/46*** *(2015.01)* ***F03D 17/00*** *(2016.01)*
*H01Q 3/26* *(2006.01)*

(52) Cooperative Patent Classification (CPC):
**H01Q 13/203; F03D 17/025;** G01R 31/11; H01Q 3/267

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**KH MA MD TN**

(71) Applicant: **Siemens Gamesa Renewable Energy A/S
7330 Brande (DK)**

(72) Inventor: **The designation of the inventor has not yet been filed**

(74) Representative: **SGRE-Association
Siemens Energy Global GmbH & Co. KG
SE I IM P Intellectual Property
Siemenspromenade 9
91058 Erlangen (DE)**

(54) **CALIBRATION DEVICE FOR LEAKY FEEDER TIME DOMAIN REFLECTOMETRY, AND WIND TURBINE**

(57) There is described a calibration device (100), in particular for a wind turbine (1), comprising:
i) a leaky feeder (110);
ii) an elongated conductor (120), in particular a lead-in and/or a lead-out cable, connected to the leaky feeder (110); iii) a transmitter (131), coupled to the elongated conductor (120), and configured to transmit an electromagnetic signal, in particular a pulse, through the elongated conductor (120) to the leaky feeder (110);
iv) a receiver (132), coupled to the elongated conductor (120) and/or to the leaky feeder (110), and configured to receive the electromagnetic signal directly and/or as a reflection; and
v) a processing device (140), configured to perform a calibration operation based on the reception of the received signal.

FIG 5

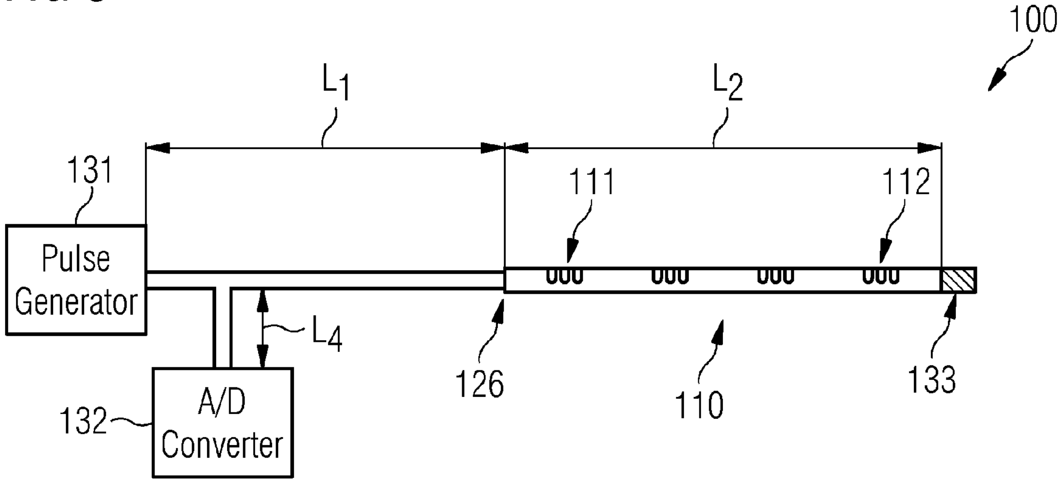

## Description

### Field of invention

The present invention relates to a calibration device comprising a leaky feeder. Further, the invention relates to a wind turbine comprising the calibration device. The invention also relates to a method of calibrating a leaky feeder path, and a specific use of time domain reflectometry. Thus, the present invention may relate to the technical field of wind turbines.

### Art Background

A leaky feeder ("radiating cable") is a cable or waveguide that is "leaky" in that it comprises slots in an outer conductor layer, so that electromagnetic signals leak in and/or out through said slots along the entire length of the leaky feeder or parts of it. Accordingly, a leaky feeder can be especially interesting for applications, where signals should be transmitted/received along an extension, for example a tunnel, a mine, or a train.

Wind turbines can be considered as an important energy production source and it can be expected that their importance and distribution will grow more and more. Accordingly, there is constant research and development undertaken to further improve the functionality of wind turbines. An important aspect in this regard may be the inspection of the wind turbine blades, in particular during operation. In this respect, a leaky feeder application may be especially useful, for example by monitoring the blade(s) using one or more leaky feeder as antenna(s) of a radar functionality.

Yet, for some applications of the leaky feeder, a calibration (of the leaky feeder path) may be necessary. In the first place, a calibration should be done as a quality check, if there is a fault, damage or change of the leaky feeder. In further (advanced) applications, it may be required to accurately determine a length information and/or a phase information. In order to determine this information, a calibration of the configuration may be needed.

Such a calibration may be conventionally done using a signal transfer "over the air" between transmitting/receiving devices, e.g. a radar functionality. Nevertheless, in case of a non-radar application (in particular no reflection of the transmitted signal), no established solution may be at hand.

### Summary of the Invention

There may be a need to calibrate a leaky feeder path (with respect to a wind turbine) in an efficient and reliable manner.

This need may be met by the subject matter according to the independent claims. Advantageous embodiments of the present invention are described by the dependent claims.

According to a first aspect of the invention, there is described a calibration device (in particular for a wind turbine), comprising:

i) a leaky feeder (comprising a plurality of slots, wherein the term "slot" may also include slot groups),
ii) at least one elongated conductor (in particular a lead-in cable and/or a lead-out cable), (electrically) connected to the leaky feeder,
iii) a transmitter (unit, e.g. a pulse generator), coupled to the (lead-in) elongated conductor, and configured to transmit an electromagnetic signal (in particular a pulse or a wave) through the elongated conductor (and through) to the leaky feeder,
iv) a receiver (unit, e.g. an A/D converter), coupled to the (lead-in or lead-out) elongated conductor (and/or to the leaky feeder) and/or configured to receive

a) the incident (direct, reflection-free) electromagnetic signal and/or
b) a reflection of the electromagnetic signal, reflected (with)in the at least one elongated conductor and/or the leaky feeder (the leaky feeder path), and

v) a processing device, configured to perform a calibration operation based on the reception (in particular the detection) of the electromagnetic signal.

According to a second aspect of the invention, there is described a wind turbine comprising:

i) a tower,
ii) a nacelle, coupled to the tower,
iii) a wind rotor, which is arranged at the nacelle, and which comprises at least one blade (in particular three blades), and
iv) a calibration device as described above.

According to a third aspect of the invention, there is described a method of calibrating an elongated conductor to leaky feeder path, in particular for a wind turbine, the method comprising:

i) transmitting an electromagnetic signal, in particular a pulse, through the elongated conductor to the leaky feeder,
ii) receiving the incident electromagnetic signal and/or receiving a reflection of the electromagnetic signal, reflected within the at least one elongated conductor and/or the leaky feeder, and
iii) performing a calibration operation based on the reception of the electromagnetic signal.

According to a fourth aspect of the invention, there is described a use (method of using) of time domain reflectometry to calibrate (the phase angle of) a conductor-to-leaky-feeder path, in particular in the context of a wind turbine.

In the context of the present document, the term "leaky feeder" may in particular refer to an elongated structure that is configured as a transmitter and/or receiver of electromagnetic waves/signals, wherein the transmission/reception occurs at specifically defined slots/apertures (leaking). An exemplary embodiment of a leaky feeder is shown in Figure 3. The leaky feeder may be configured e.g. as a leaky coaxial cable, a leaky waveguide (in particular suitable at high frequencies), or a leaky stripline.

In an embodiment, the leaky feeder comprises a plurality of slots to allow an electromagnetic signal to leak out of the leaky feeder along its (entire or parts of) length. In a further embodiment, the leaky feeder comprises a plurality of slots to allow an electromagnetic signal to leak into the leaky feeder along its (entire) length. In the present document, the term "slot" may also include slot groups. In an embodiment, the slots/slot groups may be, regularly or irregularly distributed along the length of the leaky feeder.

In an embodiment, the leaky feeder is coupled/connected to at least one of a transmitter (unit), a receiver (unit), a termination (unit), see e.g. the example of Figure 4. Hereby, the leaky feeder may be configured to transmit the signal provided by the transmitter (unit) and/or to provide a received signal to the receiver (unit).

In the context of the present document, the term "elongated conductor" may in particular refer to a conductor with a main extension in one spatial dimension, which is much larger than the extension in the other two spatial dimensions, for example a cable. The elongated conductor may serve as an electric connector between the leaky feeder and a communication-associated device, such as a transmitter, a receiver, or a termination (e.g. resistor with characteristic wave impedance of the leaky feeder). Hereby, the exact length of the elongated conductor may not be known and may have to be calibrated. A leaky feeder path may be defined as a (signal) path through the leaky feeder and the connected elongated conductor.

In the context of the present document, the term "time domain reflectometry" (TDR) may in particular refer to an established method of investigating a device by observing (reflected) waveforms of electromagnetic signals. For example, TDR is used locate faults or discontinuities in a conductor, connector, printed circuit board, or another electrical path. In case that a conductor is of a uniform impedance and properly terminated, then there may be no reflections and the remaining incident signal will be absorbed at the termination. Instead, if there are characteristic (wave) impedance variations, then (some of) the incident signal may be reflected back to the source.

In the context of the present document, the term "calibration operation" may in particular refer to any calibration that may be done with respect to a leaky feeder (in the context of a wind turbine). For example, such a calibration may be done regarding at least one slot location of the leaky feeder that can serve to determine a length information. Based on the length information (e.g. length of the elongated conductor or length from a communication-associated device to the leaky feeder (via the elongated conductor), in particular to the first slot), further calibration may be performed, for example phase angle information and/or amplitude information may be determined, and phase shifts may then be calibrated (for specific further applications, e.g. beam steering, blade inspection/monitoring, etc.).

In the context of the present document, the term "processing device" may in particular refer to any hardware and/or software suitable to perform the above described step of performing a calibration operation (based on the reception of the electromagnetic signal). The processing device may comprise one or more processors. In an example, the processing device may be implemented as one or more processing units in the calibration device or the wind turbine, respectively. In another example, the processing device may be located (at least partially) outside of the wind turbine and operate remotely.

According to an exemplary embodiment, the invention may be based on the idea that a leaky feeder path (of a wind turbine) may be calibrated in an efficient and reliable manner, based on an approach that applies time domain reflectometry. While conventionally, a calibration is done by directly transmitting a signal into/through the air and then receiving it, e.g. like in radar technology, the time domain reflectometry (TDR) technology enables a calibration operation (e.g. to determine the phase angle and/or perform a self-test of the system) within the leaky feeder itself. This is realized by receiving the incident electromagnetic signal and/or the reflected signal directly within the leaky feeder path, i.e. the transmitted signal does not leave the leaky feeder path (environment). Accordingly, no signal transmission over the air and no radar application may be necessary anymore.

The invention may thus intentionally not transmit a signal through the air, because in this case additional standards and legal regulations has to be followed. This may increase the technical effort and costs. Further, the system could be more easily interfered by external radio frequency noise. The calibration as part of the invention may be more robust to external radio frequency noise and it may allow to determine a fault in the configuration more reliably.

Exemplary Embodiments

According to an embodiment, the calibration operation comprises: deriving a length information. The length information may be determined with respect to the (lead-in) elongated conductor and/or the distance from the transmitter through the elongated conductor to the (first) slot of the leaky feeder with closest proximity to the elongated conductor.

This may provide the advantage that a versatile length information (potentially required for further calibrations) may be directly derivable. For example, the length of the elongated conductor may be determined or the length from a communication-associated device (via the elongated conductor) to the (first slot of the) leaky feeder.

In an example, the length from the communication-associated device (e.g. transmitter) to the first slot could be calculated by a time measurement of the incident and reflected electromagnetic pulse:

$$\text{length to slot} = 0.5 * \Delta t * Vf * C0$$

wherein $\Delta t$ is the time difference between the incident and reflected wave/pulse. Vf is the velocity factor and a conductor specific value, for example 0.66 for an elongated conductor and 0.88 for a leaky feeder. Preferably, Vf values of the leaky feeder and the elongated conductor are equal. C0 is the speed of light.

According to a further embodiment, the processing device is further configured to derive a phase angle information based on the length information. The phase angle information may be a valuable information for further calibration operations and applications of the leaky feeder (path).

In an example, the phase angle may be calculated as follows:

$$n = \text{length to slot}/\text{wavelength } \lambda$$

Hereby, n is an integer to be multiplied by 360°, for example in case n = 1.1, the phase angle would be 396°.

According to a further embodiment, the processing device is further configured to: (detect the incident electromagnetic signal and the reflected electromagnetic signal and) compare the incident electromagnetic signal and the reflected electromagnetic signal. Thereby, valuable calibration information may be obtained in an efficient manner.

According to a further embodiment, the transmitter comprises a pulse generator, in particular wherein the electromagnetic signal comprises a rectangular pulse. This may provide the advantage that an established and accurate means can be implemented in a straightforward manner as a transmitter (unit). Besides a pulse, also a wave may be provided. In an example, the pulse shape is not limited to rectangular.

According to a further embodiment, the receiver comprises an analog-to-digital converter, ADC. This may also provide the advantage that an established and accurate means can be implemented in a straightforward manner as a receiver (unit). Using the ADC, the received analog signal is directly converted to a digital signal that can be further processed. Thereby, additional effort may be saved.

According to a further embodiment, the at least one elongated conductor comprises a further elongated conductor (lead-out cable), connected between the leaky feeder and the receiver. This configuration (see e.g. Figure 4) may be especially suitable to detect an incident signal.

According to a further embodiment, the calibration device further comprises: a termination (e.g. a resistor), connected to the leaky feeder. In this configuration (see e.g. Figure 5), no further elongated conductor (lead-out cable) may be necessary. Thus, configuration may be especially suitable to detect a reflected signal.

According to a further embodiment, the at least one elongated conductor comprises a resistance or impedance (in particular wave impedance) different from the resistance or impedance (in particular wave impedance) of the leaky feeder, to thereby enable a reflection of the electromagnetic signal at the resistance or impedance mismatch. Such a mismatch caused by different resistance/impedance may cause a characteristic reflection at the interface between elongated conductor and leaky feeder.

In an example, there are two different characteristic wave impedances by design. For a leaky feeder, the impedance may be for example around 50 ohms. By designing a lead-in cable with a mismatch of the wave impendence, it may be possible to create a wanted reflection at the joint connection of the lead-in cable to the leaky feeder. This could be for example a 57 ohms wave impedance for the lead-in cable. This will cause a reflection of the calibration pulse at the joint connection of the lead-in cable to the leaky feeder, and therefore allow to estimate the length of the lead-in cable.

According to a further embodiment, the calibration device comprises a (mechanical/electrical) mismatch at the joint connection (interface) between the at least one elongated conductor and the leaky feeder, to thereby enable a reflection of the electromagnetic signal at the joint connection. Such an intentionally formed mismatch may cause a characteristic reflection at the interface between elongated conductor and leaky feeder.

In an example, a wanted mismatch in the characteristic wave impedance of the lead-in cable of the leaky feeder (and/or in the joint or leaky feeder itself) is provided. The joint of leaky feeder and the lead-in cable may cause a jump in the wave impedance and may therefore reflect a small part of the pulse. With this reflected pulse, it may be possible to determine the length information, e.g. of the lead-in cable.

According to a further embodiment, the electromagnetic signal is reflected at a slot (in particular the slot with closest proximity to the elongated conductor) of the leaky feeder. The slot may hereby function as an impedance to reflect a part of the incident signal. This may provide the advantage that the inherent structure of the leaky feeder can be directly used to obtain a reflection without further effort. Hereby, the position of the slot may be precisely determined and serve for determining the length information. In an example, a plurality of reflections are caused by the plurality of slots.

According to a further embodiment, the leaky feeder is at least partially located in the tower circumferential direction, in particular (bent) inside or outside of the tower. Thereby, the length extension of the leaky feeder may be exploited in an advantageous manner.

According to a further embodiment, the processing device is further configured to apply the phase angle information to calibrate a phase shift of a leaky feeder transmitted electromagnetic signal, in particular adapt the phase shift of two or more leaky feeder transmitted electromagnetic signals, e.g. to steer an electromagnetic signal beam, for example to thereby inspect/monitor a wind turbine blade.

According to a further embodiment, the method further comprising: determining a length information (with respect to the leaky feeder path) based on the received electromagnetic signal, in particular further comprising: deriving a phase angle information from the length information.

In an embodiment, the phase (angle) information may be important for advanced measurement setups, for example beam forming/steering with multiple leaky feeders parallel and/or close together.

In an embodiment, a calibration may be required to determine a length information, e.g. from the transmitter to the first slot/slot group, and to calculate with the length information the phase information. Furthermore, a "life" test of the system can be performed to detect faults like damages or moisture associated with the leaky feeder.

In an embodiment, a pulse includes multiple waves (then Fourier analysis may be performed). The term "electromagnetic waves" may hence include pulses (as a special kind of wave).

In an embodiment, a direct connection of the transmitter/receiver unit to the leaky feeder (without an elongated conductor in between) is established.

The aspects defined above and further aspects of the present invention are apparent from the examples of embodiment to be described hereinafter and are explained with reference to the examples of embodiment. The invention will be described in more detail hereinafter with reference to examples of embodiment but to which the invention is not limited.

## Brief Description of the Drawings

Figure 1 shows a wind turbine with a calibration device in accordance with an exemplary embodiment of the present invention.

Figure 2 shows a leaky feeder in accordance with an exemplary embodiment of the present invention.

Figure 3 shows a leaky feeder path in accordance with an exemplary embodiment of the present invention.

Figure 4 shows a calibration device in accordance with an exemplary embodiment of the present invention.

Figure 5 shows a calibration device in accordance with a further exemplary embodiment of the present invention.

Figure 6 shows a reflected pulse in accordance with an exemplary embodiment of the present invention.

Figure 7 shows voltage and current of pulses over time in accordance with an exemplary embodiment of the present invention.

Figure 8 shows an incident pulse and a reflected pulse in accordance with an exemplary embodiment of the present invention.

Figure 9 shows an incident pulse and a reflected pulse in accordance with a further exemplary embodiment of the present invention.

Figure 10 shows a method of calibrating a leaky feeder path in accordance with an exemplary embodiment of the present invention.

Detailed Description of the Drawings

The illustration in the drawing is schematic. It is noted that in different figures, similar or identical elements or features are provided with the same reference signs or with reference signs, which are different from the corresponding reference signs only within the first digit. In order to avoid unnecessary repetitions elements or features which have already been elucidated with respect to a previously described embodiment are not elucidated again at a later position of the description.

Further, spatially relative terms, such as "front" and "back", "above" and "below", "left" and "right", et cetera are used to describe an element’s relationship to another element(s) as illustrated in the figures. Thus, the spatially relative terms may apply to orientations in use which differ from the orientation depicted in the figures. Obviously all such spatially relative terms refer to the orientation shown in the figures only for ease of description and are not necessarily limiting as an apparatus according to an embodiment of the invention can assume orientations different than those illustrated in the figures when in use.

**Figure 1** shows a wind turbine 1 with a calibration device 100 in accordance with an exemplary embodiment of the present invention. The wind turbine 1 comprises a tower 2, which is mounted on a non-depicted fundament. A nacelle 3 is arranged on top of the tower 2. In between the tower 2 and the nacelle 3, a yaw angle adjustment device (not shown) is provided, which is capable of rotating the nacelle around a vertical yaw axis Z.

The wind turbine 1 further comprises a wind rotor 5 having one or more rotational blades 4 (in the perspective of Figure 1 only two blades 4 are visible). The wind rotor 5 is rotatable around a rotational axis Y. In general, when not differently specified, the terms axial, radial and circumferential in the following are made with reference to the rotational axis Y.

The blades 4 extend radially with respect to the rotational axis Y. The wind turbine 1 comprises an electric generator 6 having a stator 11 and a rotor 12. The rotor 12 is rotatable with respect to the stator 11 about the rotational axis Y to generate electrical power. The electric generator 6 and the generation of electrical power through the present invention is not a specific object of the present invention and therefore not described in further detail.

**Figure 2** shows a leaky feeder 110 in accordance with an exemplary embodiment of the present invention. In this example, the leaky feeder 110 is configured as a leaky coaxial cable. The center of the leaky feeder is a conductor 116, e.g. a copper cable/wire. The conductor 116 is embedded (encapsulated) in a dielectric material layer 117. Further, around the dielectric material layer 117, there is arranged a shielding layer (outer conductor) 118, e.g. a metal/copper layer. A plurality of slots (apertures) 112 is formed in said shielding layer 118. Thereby, it is enabled to transmit/receive electromagnetic signal along the length of the leaky feeder 110. Since the transmission/reception takes (essentially) only place at the slots, it is termed "leaking". Optionally, a protection layer (cable jacket), in particular a dielectric such as rubber material, more in particular with low optical coverage, can be arranged around the shielding layer 118. The slots 112 are located with predefined positions and distances between each other. The first slot 111 is the outermost slot with respect to the input or output of the leaky feeder 110.

For example, an elongated conductor (not shown in this Figure) can be connected to the leaky feeder 110 in closest proximity to the first slot 111.

**Figure 3** shows a leaky feeder path 125 in accordance with an exemplary embodiment of the present invention. A first leaky feeder 110a is arranged at a wind turbine tower 2 and coupled at its extremities to communication-associated devices 130, in this example between a transmitter 131 and a terminator 133, e.g. a resistor. The connection to the transmitter 131 is realized by an elongated conductor 120a that serves as a lead-in cable, while the leaky feeder 110a is connected to the termination 133 by a further elongated conductor 120b that serves as a lead-out cable. In a comparable manner, a further leaky feeder 110b is connected through a lead-in cable 120c to a termination 133 and through a lead-out cable 120d to a receiver 132.

The transmitter 131 provides an electromagnetic signal through the lead-in cable 120a to the leaky feeder 110a, which transmits said signal along its entire length. In this specific example, the transmitted signal is reflected by a blade 4 of the wind turbine 1. Said reflected signal is then received by the further leaky feeder 110b at a specific position. The further leaky feeder 110b provides the received signal through the lead-out cable 120d to the receiver 132. In this configuration, a radar can be realized that can be used to inspect/monitor the wind turbine blade 4.

**Figure 4** shows a calibration device 100 in accordance with an exemplary embodiment of the present invention. The calibration device 100 comprises a leaky feeder 110 with a plurality of slots 112 and slot groups 115. A first elongated conductor 120, configured as a lead-in cable, electrically connects the leaky feeder 110 to a transmitter unit 131. A second elongated conductor 121, configured as a lead-out cable, connects the leaky feeder 110 to a receiver unit 132.

The transmitter unit 131 is configured as a pulse generator, configured to transmit an electromagnetic signal, being an incident a pulse (e.g. a rectangular pulse) through the first elongated conductor 120 and the leaky feeder 110. The receiver unit 132 is implemented as an analog-to-digital (A/D) converter, configured to receive the incident (direct) pulse after propagation through the elongated conductors 120, 121 and the leaky feeder 110.

Three distances L1, L2, L3 are indicated, which can be determined with the illustrated set-up. L1 is the length between transmitter 131 and the joint connection 126 between first elongated conductor 120 and leaky feeder 110. L2 is the length between the joint connection 126 and the first slot 111 of the leaky feeder 110. L3 is the length from the first slot 111 to the receiver 132.

With this set-up, a check of the leaky feeder 110 is possible. A (rectangular) pulse will be generated by a pulse generator 131 and is fed into the leaky feeder path 125. At the other end of the cable configuration, an analog to digital converter 132 is placed and will be used as receiver. The ADC is equipped with a termination resistance 133 with the same value of the wave impedance of the leaky feeder path 125 (cable combination). This might be most for example 50 ohms. To perform a simple "life" test, a single pulse is fed into the path 125, and the ADC 132 is checking, if it can receive the pulse. If it is not possible to receive the pulse, there may be a damage of the cables 125 or joints/connectors 126.

**Figure 5** shows a calibration device 100 in accordance with a further exemplary embodiment of the present invention. The set-up is comparable to the one described for Figure 4 with the difference that the receiver unit 132 is not coupled to a lead-out cable 121 (second elongated conductor), but instead (in this example via a T-joint) to the lead-in cable 120 (first elongated conductor). In this configuration, the lead-out cable 121 is obsolete and replaced by a termination 133.

Instead of L3, the length L4 can be determined, i.e. the length between the receiver unit 132 and the coupling point (T-joint) to the lead-in cable 120.

In comparison to the example of Figure 4, the receiver 132 does not receive the incident electromagnetic signal/pulse, but instead the reflected signal pulse in this configuration.

Here, the transmitter 131 is connected to one end of the leaky feeder 110, while the other end is terminated. The receiver 132 is connected via a T-joint (with an impedance matching network) close to the pulse generator 131, sending a (rectangular) pulse. In case there is an open or short in the cable configuration 125, the pulse will be reflected. The receiver 132 will see the incident and reflected pulse. If the cable configuration 125 is fine, the receiver 132 will mainly detect the incident pulse, except, reflections on the slots 112 of the leaky feeder 110.

Joint connection(s) 126 and also slots 112 of the leaky feeder 110 will work as small mismatches of the wave impedance of the cables and therefore also reflect a small part of the pulse energy. This principle is established and can be used to determine the length information, e.g. from the pulse generator 131 to the first slot 111. With the length information, it is possible to calculate the phase angle information (phase offset) to shift the phase for a specific needed purpose (e.g. beam steering).

**Figure 6** shows a received reflected pulse in accordance with an exemplary embodiment of the present invention. Said pulse is received at the receiver 132 in the example of Figure 5. Depending on the resistance of the termination 133 (here a resistor), quite different reflected pulses a) to e) are received.

**Figure 7** shows voltage and current of pulses over time in accordance with an exemplary embodiment of the present invention. The upper scheme shows the voltage (positive and negative values) over time for an incident pulse, a reflected pulse, and a mixture of an incident/reflected pulse. The lower scheme shows a current (only positive values) over time for an incident pulse, a reflected pulse, and a mixture of incident/reflected pulse.

**Figure 8** shows the intensity of an incident pulse and a reflected pulse over time in accordance with an exemplary embodiment of the present invention. The receiver 132 detects the incident pulse and later-on the reflected pulse with a comparable intensity. This can be the case for an open-cable configuration.

**Figure 9** shows the intensity of an incident pulse and a reflected pulse over time in accordance with an exemplary embodiment of the present invention. The receiver 132 detects the incident pulse and later-on the reflected pulse, wherein the later comprises a significantly lower intensity. This can be the case, when the pulse is reflected at the joint connection 126, in particular if a jump of wave impedance is implemented at said joint connection 126. Alternatively, a slot 112 of the leaky feeder 110 could provide such a reflected signal.

**Figure 10** shows a method of calibrating a leaky feeder path 125, for example according to the configuration of Figure 5, in accordance with an exemplary embodiment of the present invention. In the first place, a (rectangular) pulse is sent from the transmitter 131. The reflected (or incident) pulse is then received by the receiver 132. This first step can be applied as a "life" test of the system. Afterwards, the time difference between incident and reflected pulse detection can be determined. The amplitude (intensity) of the incident pulse should be significantly higher than of the reflected pulse (see Figure 9). If this is not the case (see Figure 8), there might be a failure, e.g. a short circuit or an open cable.

From the time difference, a length information can be derived, which could be further used to determine a phase angle information. The last steps are performed, as indicated, by a processing device 140.

It should be noted that the term "comprising" does not exclude other elements or steps, and the use of the item "a" does not exclude multiplicity. Elements described in conjunction with various embodiments can also be combined. It should also be noted that reference signs in the claims should not be interpreted as limiting the scope of the claims.

Independent of the grammatical term usage, individuals with male, female or other gender identities are included within the term.

**Claims**

1. A calibration device (100), in particular for a wind turbine (1), comprising:

    a leaky feeder (110);
    at least one elongated conductor (120, 121), in particular a lead-in (120) and/or a lead-out cable (121), connected to the leaky feeder (110);
    a transmitter (131), coupled to the at least one elongated conductor (120), and configured to transmit an electromagnetic signal, in particular a pulse, through the at least one elongated conductor (120) to the leaky feeder (110);
    a receiver (132), coupled to the at least one elongated conductor (120, 121), and configured to receive the incident electromagnetic signal and/or
    a reflection of the electromagnetic signal, reflected in the at least one elongated conductor (120, 121) and/or the leaky feeder (110); and
    a processing device (140), configured to perform a calibration operation based on the reception of the electromagnetic signal.

2. The calibration device (100) according to claim 1, wherein the calibration operation comprises:

    deriving a length information,
    in particular with respect to:

        the at least one elongated conductor (120), and/or
        the distance from the transmitter (131) through the elongated conductor (120) to the slot (111) of the leaky feeder (110) with closest proximity to the elongated conductor (120).

3. The calibration device (100) according to claim 2, wherein the processing device (140) is further configured to: derive a phase angle information and/or an amplitude information based on the length information.

4. The calibration device (100) according to any one of the preceding claims, wherein the processing device (140) is further configured to:
compare the incident electromagnetic signal and the reflected electromagnetic signal.

5. The calibration device (100) according to any one of the preceding claims,

    wherein the transmitter (131) comprises a pulse generator, in particular wherein the electromagnetic signal comprises a pulse; and/or
    wherein the receiver (132) comprises an analog-to-digital converter, ADC.

6. The calibration device (100) according to any one of the preceding claims, further comprising:

    wherein the at least one elongated conductor (120, 121) comprises a further elongated conductor (121), connected between the leaky feeder (110) and the receiver (132); or
    a termination (133), connected to the leaky feeder (110) .

7. The calibration device (100) according to any one of the preceding claims,
wherein the at least one elongated conductor (120) comprises a resistance or impedance, in particular wave impedance, different from the resistance or impedance, in particular wave impedance, of the leaky feeder (110), to thereby enable a reflection of the electromagnetic signal at the resistance or impedance mismatch.

8. The calibration device (100) according to any one of the preceding claims,
comprising a mismatch at the joint connection (126) between the at least one elongated conductor (120) and the leaky feeder (110), to thereby enable a reflection of the electromagnetic signal at the joint connection (126).

9. The calibration device (100) according to any one of the preceding claims,

wherein the electromagnetic signal is reflected at a slot (112), in particular the slot (111) with closest proximity to the elongated conductor (120), of the leaky feeder (110).

**10.** The calibration device (100) according to any one of preceding claims 3 to 9, wherein the processing device (140) is further configured to:

apply the phase angle information to calibrate a phase shift of a leaky feeder (110) transmitted electromagnetic signal, in particular
adapt the phase shift of two or more leaky feeder (110) transmitted electromagnetic signals, to steer an electromagnetic signal beam,
more in particular to thereby inspect a wind turbine blade (4) .

**11.** A wind turbine (1) comprising:

a tower (2);
a nacelle (3), coupled to the tower (1);
a wind rotor (5), which is arranged at the nacelle (3), and which comprises at least one blade (4); and
a calibration device (100) according to any one of the preceding claims.

**12.** The wind turbine (1) according to claim 11, wherein the leaky feeder (110) is at least partially located in the tower circumferential direction, in particular inside or outside of the tower (2).

**13.** A method of calibrating a leaky feeder path (125), comprising an elongated conductor (120) connected to a leaky feeder (110), in particular for a wind turbine (1), the method comprising:

transmitting an electromagnetic signal, in particular a pulse, through the elongated conductor (120) to the leaky feeder (110);
receiving the incident electromagnetic signal and/or receiving a reflection of the electromagnetic signal, reflected in the elongated conductor (120) and/or the leaky feeder (110); and
performing a calibration operation based on the reception of the electromagnetic signal.

**14.** The method according to claim 13, wherein performing the calibration operation further comprises:

deriving a length information from the received electromagnetic signal; and
deriving a phase angle information from the length information.

**15.** Using time domain reflectometry to calibrate a conductor-to-leaky-feeder (115) path, in particular in the context of a wind turbine (1).

FIG 1

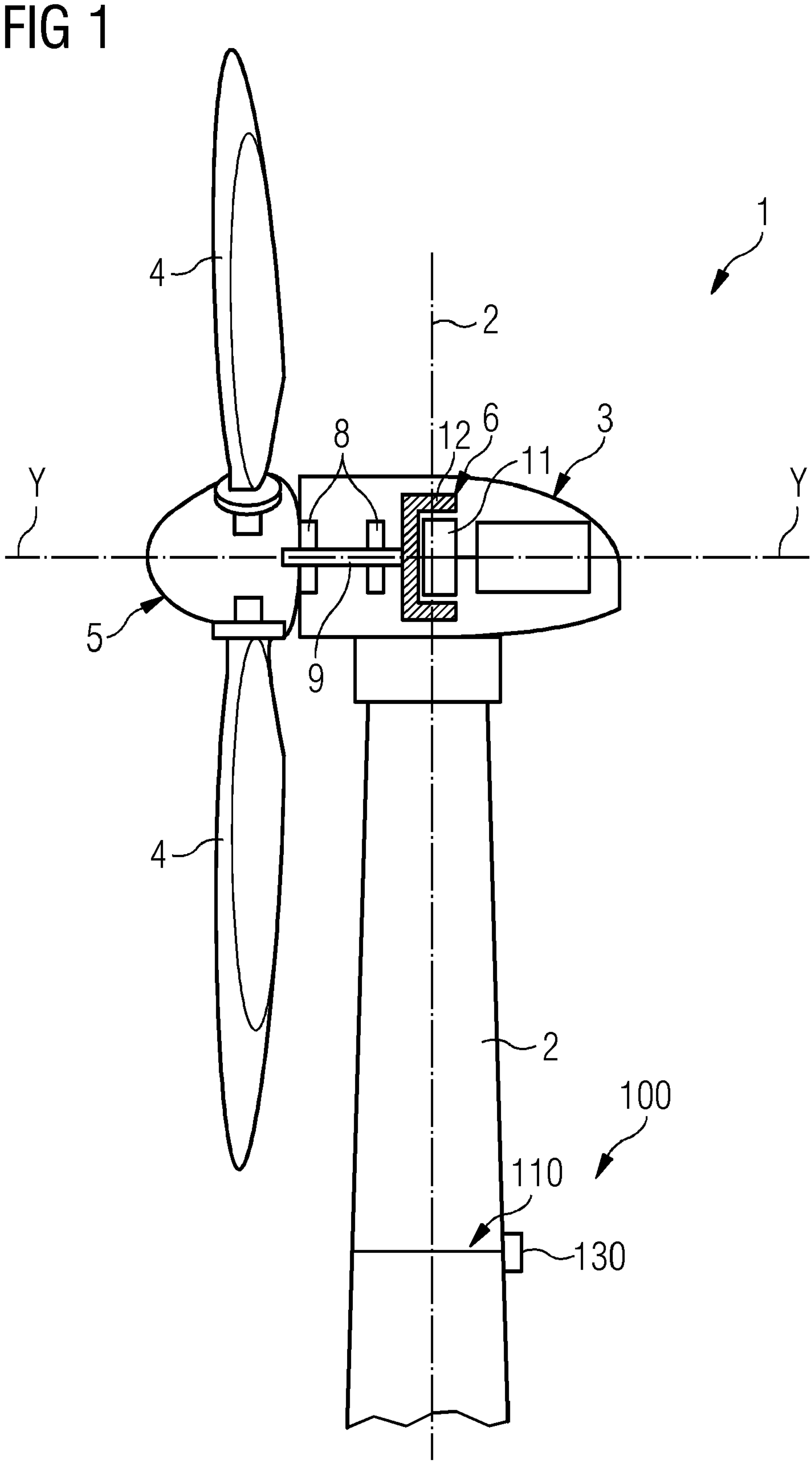

FIG 2

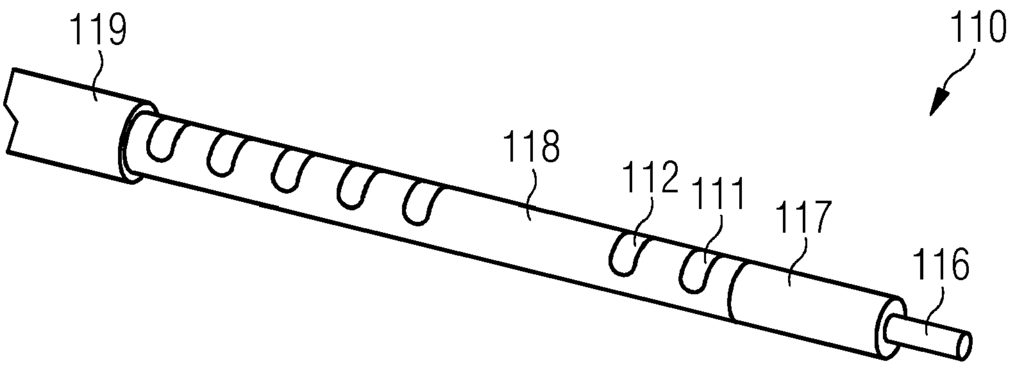
119
110
118
112
111
117
116

FIG 3

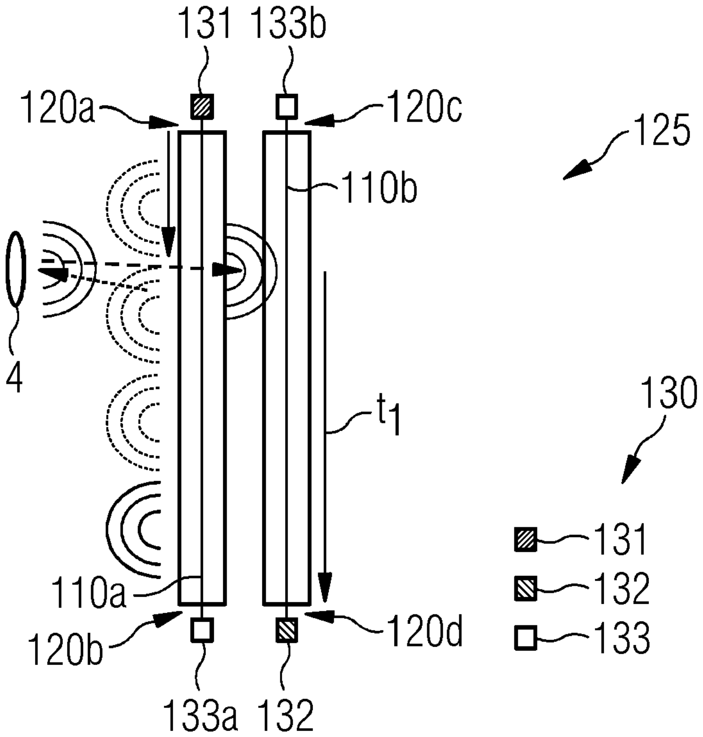
131
133b
120a
120c
125
110b
4
$t_1$
130
131
132
133
110a
120b
120d
133a
132

FIG 4

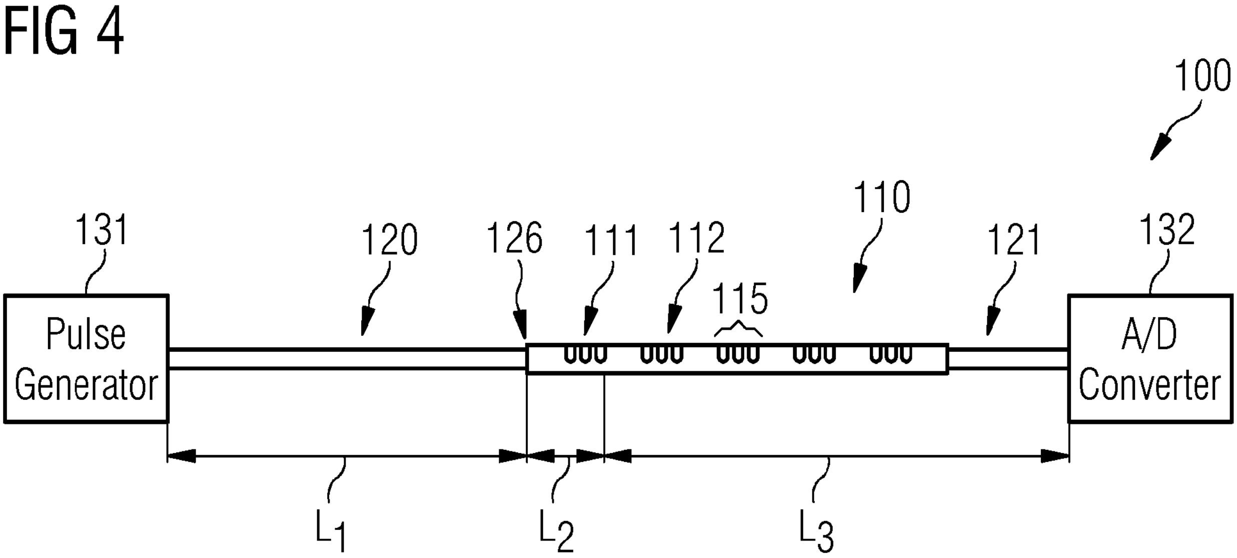
100
131
120
126
111
112
110
115
121
132
Pulse Generator
A/D Converter
L1
L2
L3

FIG 5

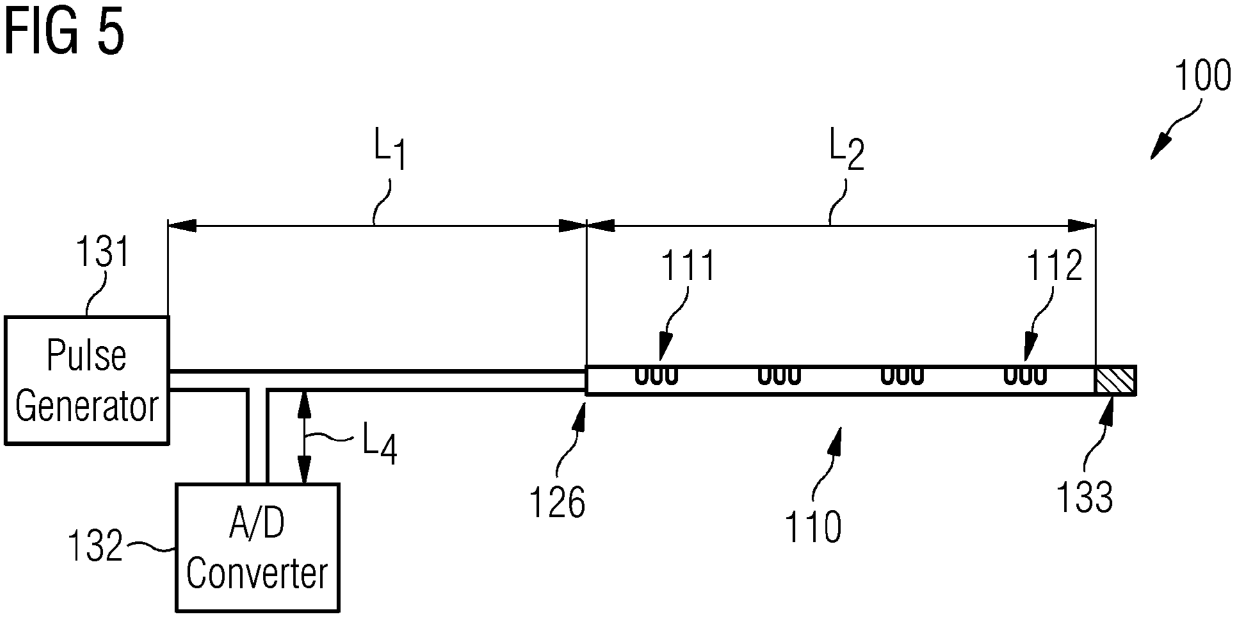
100
L1
L2
131
111
112
Pulse Generator
L4
126
110
133
132
A/D Converter

FIG 6

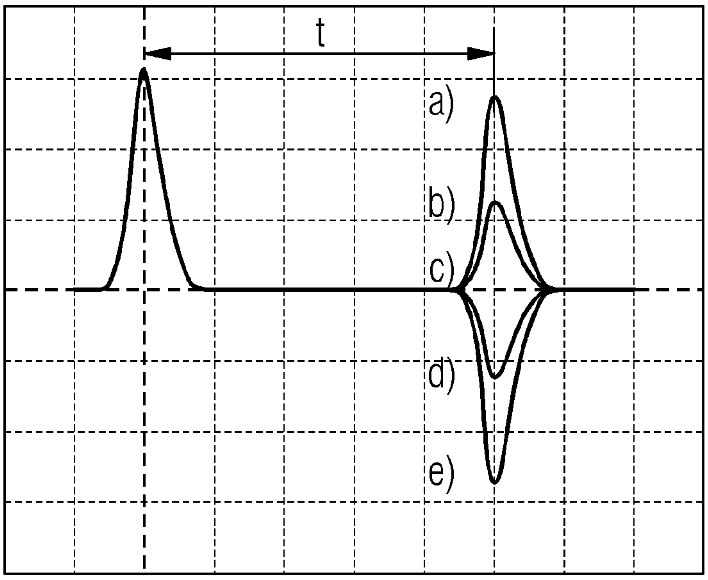
t
a)
b)
c)
d)
e)

FIG 7

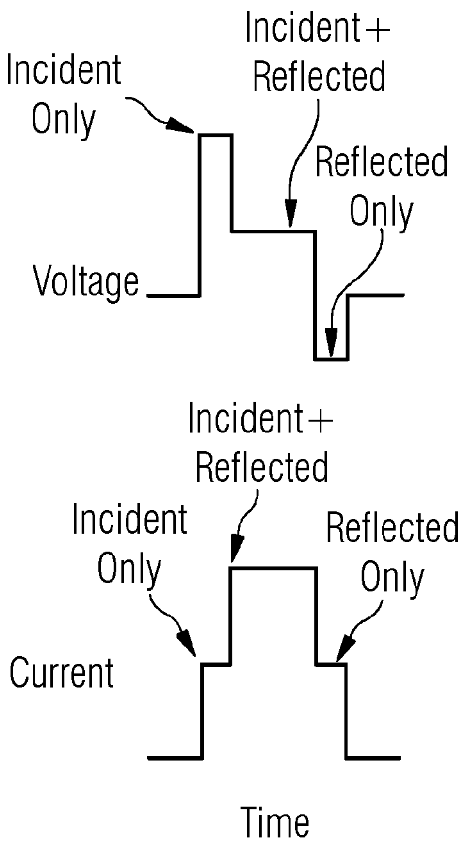
Incident Only
Incident+ Reflected
Reflected Only
Voltage
Incident+ Reflected
Incident Only
Reflected Only
Current
Time

FIG 8

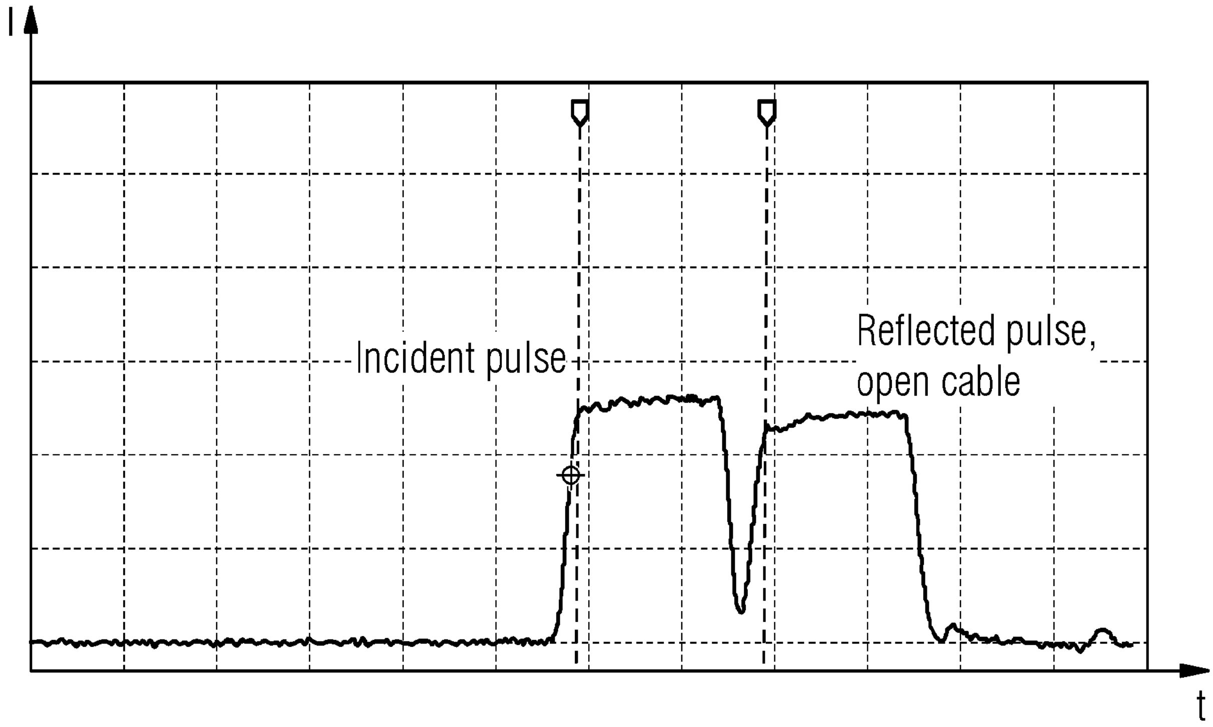
I
Incident pulse
Reflected pulse,
open cable
t

FIG 9

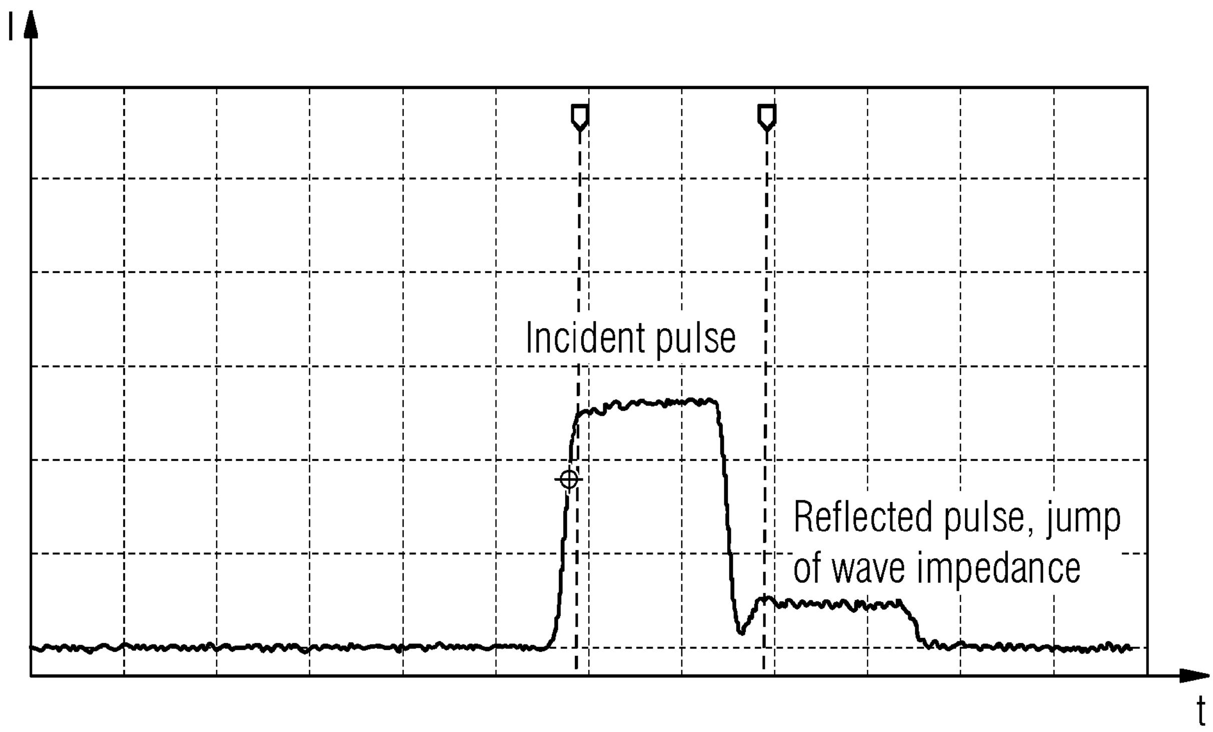
I
Incident pulse
Reflected pulse, jump
of wave impedance
t

FIG 10

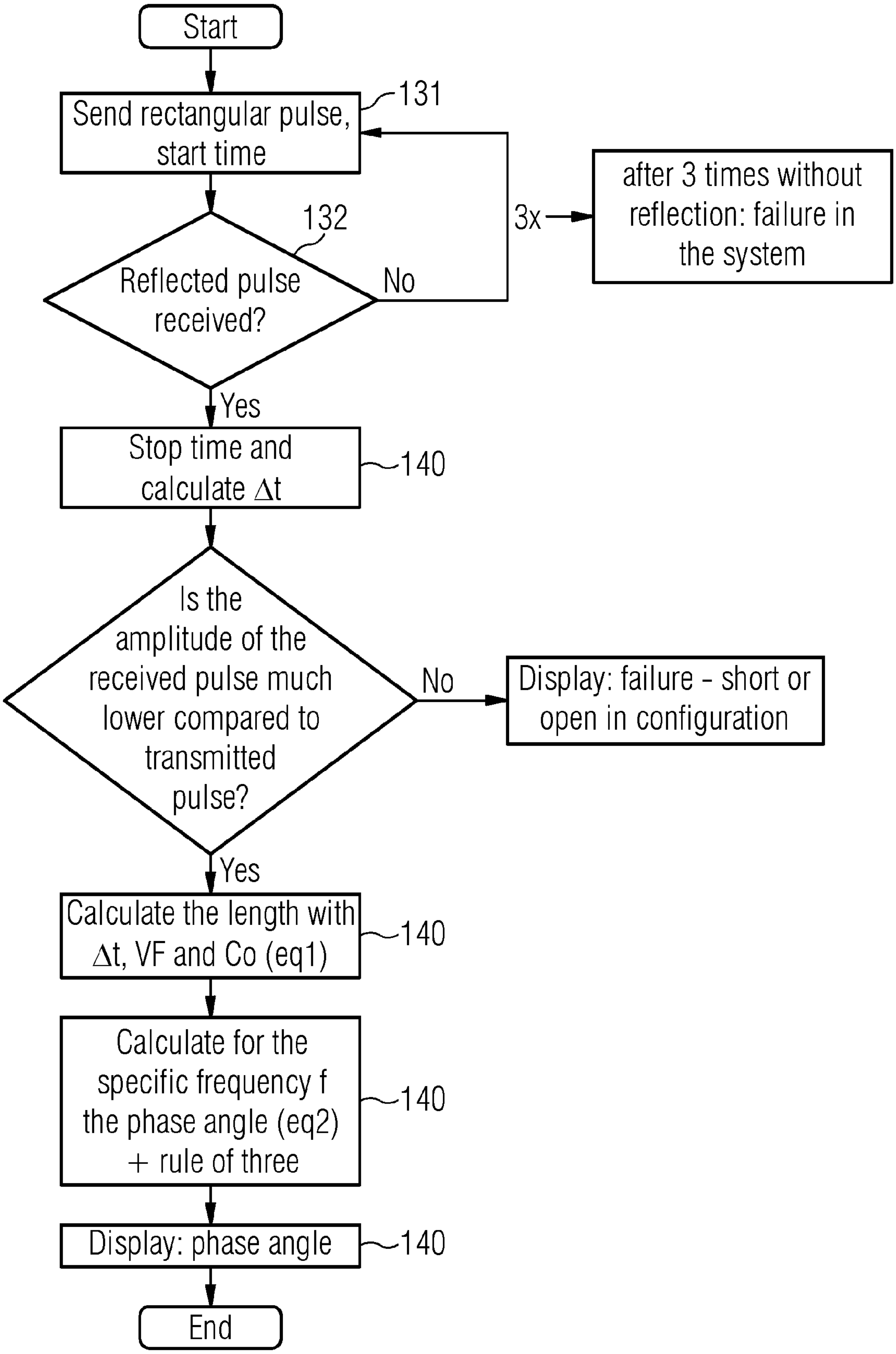
Start
Send rectangular pulse, start time
131
Reflected pulse received?
132
No
3x
after 3 times without reflection: failure in the system
Yes
Stop time and calculate Δt
140
Is the amplitude of the received pulse much lower compared to transmitted pulse?
No
Display: failure - short or open in configuration
Yes
Calculate the length with Δt, VF and Co (eq1)
140
Calculate for the specific frequency f the phase angle (eq2) + rule of three
140
Display: phase angle
140
End

Europäisches Patentamt
European Patent Office
Office européen des brevets

# EUROPEAN SEARCH REPORT

Application Number
EP 23 16 1381

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | FR 3 059 780 A1 (ELECTRICITE DE FRANCE [FR]) 8 June 2018 (2018-06-08)<br>* figure 1 *<br>* figure 2 *<br>* page 1, line 2 - line 4 *<br>* page 2, line 7 - line 20 *<br>* page 6, line 3 - line 5 *<br>* page 6, line 20 - line 27 *<br>* page 7, line 12 - line 15 *<br>----- | 1,4, 10-13 | INV.<br>H01Q13/20<br>G01R31/11<br>H04B3/46<br>F03D17/00<br><br>ADD.<br>H01Q3/26 |
| X | US 2022/333969 A1 (LITTLEFORD SYDNEY JOSEPH [GB]) 20 October 2022 (2022-10-20)<br>* figure 1 *<br>* figure 2 *<br>* figure 4 *<br>* figure 8 *<br>* paragraph [0029] *<br>* paragraph [0084] *<br>* paragraph [0142] - paragraph [0143] *<br>* paragraph [0148] *<br>* paragraph [0233] *<br>* paragraph [0265] *<br>----- | 1-9, 13-15 | |
| | | | TECHNICAL FIELDS SEARCHED (IPC) |
| A | EP 3 626 965 A1 (SIEMENS GAMESA RENEWABLE ENERGY AS [DK]) 25 March 2020 (2020-03-25)<br>* figure 1 *<br>* figure 4 *<br>* paragraph [0018] *<br>* paragraph [0023] *<br>----- | 10-12 | H01Q<br>G01R<br>F03D<br>H04B |
| A | US 2020/412003 A1 (LEE ROBERT [US] ET AL) 31 December 2020 (2020-12-31)<br>* figure 4A *<br>* paragraph [0056] *<br>----- | 5 | |

The present search report has been drawn up for all claims

1

| Place of search | Date of completion of the search | Examiner |
|---|---|---|
| The Hague | 9 August 2023 | Kalialakis, Christos |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

# ANNEX TO THE EUROPEAN SEARCH REPORT ON EUROPEAN PATENT APPLICATION NO.

EP 23 16 1381

This annex lists the patent family members relating to the patent documents cited in the above-mentioned European search report.
The members are as contained in the European Patent Office EDP file on
The European Patent Office is in no way liable for these particulars which are merely given for the purpose of information.

09-08-2023

| Patent document cited in search report | Publication date | Patent family member(s) | Publication date |
|---|---|---|---|
| FR 3059780 A1 | 08-06-2018 | CN 110249217 A | 17-09-2019 |
| | | EP 3548879 A1 | 09-10-2019 |
| | | FR 3059780 A1 | 08-06-2018 |
| | | WO 2018100167 A1 | 07-06-2018 |
| US 2022333969 A1 | 20-10-2022 | AU 2022202330 A1 | 03-11-2022 |
| | | EP 4075106 A1 | 19-10-2022 |
| | | GB 2605809 A | 19-10-2022 |
| | | US 2022333969 A1 | 20-10-2022 |
| EP 3626965 A1 | 25-03-2020 | CN 112689712 A | 20-04-2021 |
| | | EP 3626965 A1 | 25-03-2020 |
| | | EP 3841300 A1 | 30-06-2021 |
| | | US 2022034304 A1 | 03-02-2022 |
| | | WO 2020057917 A1 | 26-03-2020 |
| US 2020412003 A1 | 31-12-2020 | NONE | |

EPO FORM P0459

For more details about this annex : see Official Journal of the European Patent Office, No. 12/82